# EUROPEAN PATENT SPECIFICATION

(11) **EP 0 858 212 B1**
(45) Date of publication and mention of the grant of the patent: **29.05.2002**
(21) Application number: 98870024.1
(22) Date of filing: 06.02.1998
(51) Int. Cl.: H04N 3/15

(54) **Method for obtaining a high dynamic range read-out signal of a CMOS-based pixel structure and such CMOS-based pixel structure**
Verfahren zur Erzeugung eines Auslegesignals einer auf CMOS basierender Pixelstruktur und eine solche auf CMOS basierender Pixelstruktur
Méthode pour obtenir un signal de lecture d'une structure de pixel basée sur le CMOS et une telle structure de pixel basée sur le CMOS

(30) Priority: 10.02.1997 US 37531 P; 04.06.1997 EP 97870084; 22.09.1997 EP 97870142; 24.10.1997 EP 97870169
(43) Date of publication of application: 12.08.1998
(73) Proprietor: FILL FACTORY, 2800 Mechelen (BE)
(72) Inventor: Dierickx, Bart, 2640 Mortsel (BE); Scheffer, Danny, 4567 DG Clinge (NL)
(74) Representative: Bird, Ariane

(56) References cited:
- EP-A- 0 739 039
- EP-A- 0 773 667
- US-A- 4 647 975
- US-A- 4 839 735
- US-A- 5 164 832
- US-A- 5 258 845

## Description

### Field of the invention

The present invention relates to solid state imaging devices being manufactured in a CMOS- or MOS-technology. More particularly, the present invention is related to a method of obtaining a read-out signal of a CMOS-based pixel structure with a large dynamic range.

The present invention is also related to a new pixel structure and to imaging devices having such pixel structure involved in the method of the present invention.

### Background of the invention and problem definition

Solid state imaging devices are well known. These devices find a widespread use in camera systems. In such application, a matrix of pixels comprising light sensitive elements constitutes an image sensor, which is mounted in the camera system. The signal of said matrix is measured and multiplexed to a video-signal.

Commonly solid state image devices are implemented in a CCD-technology or in a CMOS- or MOS-technology.

Among the image sensors implemented in a CMOS- or MOS-technology, CMOS or MOS image sensors with passive pixels and CMOS or MOS image sensors with active pixels are distinguished. An active pixel is configured with means integrated in the pixel to amplify the charge that is collected on the light sensitive element. Passive pixels do not have said means and require a charge-sensitive amplifier that is not integrated in the pixel and is connected with a long line towards the pixel.

There is an ongoing effort to increase the performance of CMOS or MOS image sensors such that a comparable image quality is obtained as the one obtained with high end CCD imagers. Due to the miniaturisation of the technology of CMOS based electronic circuits, it is further possible to realise complex CMOS- or MOS-based pixels as small as CCD-based pixels. It is a main advantage of CMOS- or MOS-based image sensors that CMOS technology is being offered by most foundries whereas CCD-technology is rarely offered and a more complex and expensive technology option.

In the co-pending patent applications EP-A-0773667 and EP-97870084.7 pixel structures and methods of addressing them are described which yield, alone or in combination, the above-mentioned goals.

In general, it must be recognised that for an imaging device, three specifications that are difficult to match are to be met:
- the sensitivity of the image device, especially in the dark,
- the cosmetic quality of the image (this means that the image should be flawless), and
- the requirement of a response with a high dynamic range.

Image sensors having a non-linear response such as a logarithmic response are known from, e.g. EP-A-0739039.

However, most of the image sensors with passive or active pixels show a linear voltage-to-light response. This means that their dynamic range is limited by the dynamic range of the linear response. For instance, if the linear output voltage has an S/R ratio of about 250 (which is a typical value) the corresponding dynamic range will be the same.

Image sensors with a double linear response or multiple linear response are known. In such sensors, two or more linear pieces of optical response are combined in one electrical output signal, outside the pixel. Presently, the classical image sensors can be used to obtain such double linear response image by capturing two images with different sensitivity and combining them.

Document US-A-5164832 discloses a CCD-circuit having a response curve that has two sensitivity ranges. The CCD circuit has a clipping gate that is in a parallel configuration on the CCD. In order to obtain a response curve, the light integration period is splitted in a first and second integration periods. During the first integration period, the clipping gate is set to a specific DC voltage that removes the signals being generated by a high light intensity impinging on the CCD. During the second integration period, this limitation is removed. The high signals will only add to the result during the second period only, low signals will add all the time.

The collected photocharge during the first period of the integration time is limited, during the second period, the limitation is removed. This limitation that can be removed is obtained with a clipping gate that is set to one DC voltage during the first period, and to another during the second period. This said gate continuously removes charge that is in excess.

### Aims of the invention

The present invention is defined in the appended claims. It aims to disclose an active or passive pixel structure such that with one single pixel, a double or multiple linear, voltage-to-light response can be obtained.

The present invention further aims to disclose a method of reading out an active or passive pixel structure such that a double or multiple linear voltage-to-light response can be obtained in one single image scan.

### Main characteristics of the present invention

The present invention is related to a method for obtaining a read-out signal of a MOS-based pixel structure having at least a photosensitive element with an output node and a memory element with a first switch therebetween. The method comprises the steps of while acquiring charge carriers on said output node of said photosensitive element, said charge carriers being converted from electromagnetic radiation on the photosensitive element, after a first time period creating a first signal, and after a second time period, creating a second signal, said read-out signal being a combination of at least said first and said second signals.

According to the present invention, there is no limitation to the amount of collected charges in none of the integrated periods. The signal collected during the first period is memorized by a switch which shortly closes and opens between the period. During the second period, there is no electrical contact between the output node and the memory element. The switch can thus be in the same state in both period of time. After a second period, there are thus two charge packets, each obtained during a different time. In order to read-out, these two charge packets are then combined into the read-out signal. This combination is done, e.g. by adding or subtracting this charge packets or by adding or subtracting them in the circuitry external to the sensor.

The method is more particularly performed by the following sequence:
- after a first time period, said first switch is opened thereby storing a first number of said charge carriers on said memory element and creating a first signal;
- and after a second time period, a second number of said charge carriers is stored on said output node creating a second signal, said read-out signal being a combination of at least said first and said second signals.

It should be understood that the terms "creating" and "combining" mean treating the different signals in the electronic circuitry according to the basic knowledge of the person skilled in the art.

The photosensitive element can be any element such as a photodiode, a photogate, a phototransistor or a photoresistor.

The above-mentioned steps and/or concept can be repeated for a number of time periods being larger than 2.

According to a preferred embodiment, the method further comprises the steps:
- after said second time period, creating a first intermediate signal from said first signal,
- thereafter opening and closing said first switch thereby creating a second intermediate signal, and;
- combining at least said first and said second intermediate signals in order to obtain said read-out signal.

Preferably, essentially all the charge carriers being converted from electromagnetic radiation impinging on said photosensitive element during said first time period are creating said first signal, except for the normal saturation or anti-blooming of the pixel.

More preferably, essentially all the charge carriers being converted from electromagnetic radiation impinging on said photosensitive element during said second time period are creating said second signal.

According to a first preferred embodiment, the read-out signal is an average or a weighed average of at least said first and said second signals.

According to another preferred embodiment, the read-out signal is a subtraction of said second signal and said first signal.

According to a preferred embodiment, a correlated double-sampling is performed using an extra-step of closing a second switch which is placed in series with the photosensitive element in order to have a reset of said photosensitive element and thereby creating a third signal, said read-out signal being a combination of first, second and third signals.

Preferably, in this case the read-out signal is a combination of the subtraction of third and first signals and subtraction of third and second signals.

According to another preferred embodiment, the read-out signal can be a combination of the subtraction of second and first signals and subtraction of third and second signals.

According to another preferred embodiment of the present invention, the read-out signal can be a combination of the subtraction of second and first signals and subtraction of third and first signals.

The present invention is also related to a MOS or CMOS based pixel structure comprising at least:
- a photosensitive element for converting electromagnetic radiation into charge carriers and being connected to a reset switch and to a supply voltage;
- a memory element being connected to an amplifier, and
- a first switch in-between said photosensitive element and said memory element, said first switch being opened causing a first number of said charge carriers being stored on said memory element.

The memory element is preferably an analog memory element such as a capacitor and the switches present in the pixel structure as well as the memory element are preferably MOS transistors. The capacitor can be in fact a parasitic capacitor being formed by the interconnect lines in the pixel.

The present invention is also related to a CMOS image device having a geometric configuration of pixel, at least part of the pixels having the structure described hereabove.

### Brief description of the figures

- Figure 1a and 1b: show a schematic functional representation of the pixel structure according to embodiments of the present invention.
- Figure 2a and 2b: represent the architecture of a pixel according to specific embodiments of the present invention.
- Figure 3a: represents a typical response of the pixel of figure 2.
- Figure 3b: represents the different possibilities for the slope of the response varying by the electronic shutter ratio.
- Figure 4: represents a possible embodiment of the pixel structure according to the present invention.
- Figure 5: represents a method of driving and reading the pixel.

### Description of preferred embodiments of the present invention

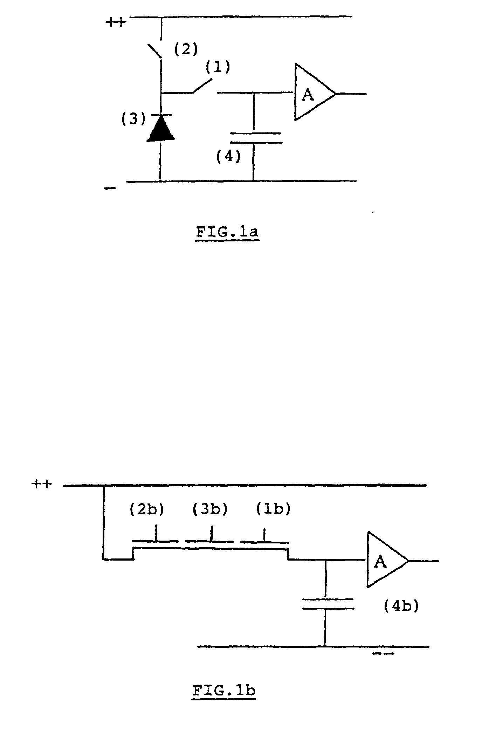

Figure 1 represents a functional pixel structure according to an embodiment of the invention wherein a memory element (4) is provided. In this figure 1, (3) is a photosensitive element such as a photoreceptor or photodiode, which can be reset by a switch (2). The signal generated by the photodiode can be periodically sampled by another switch (1) on a capacitor (4). The resulting voltage can then be multiplexed in a classical way over circuitry represented by the amplifier A.

According to one preferred embodiment, such amplifier A is placed within the pixel structure in order to have an active pixel. According to another preferred embodiment, the amplifier A can be placed outside of the pixel structure in order to have a passive pixel structure.

This pixel structure is able to perform the method of the invention for obtaining a read-out signal as described and therefore is able to realise a double or multiple linear light-to-voltage response in one single pixel.

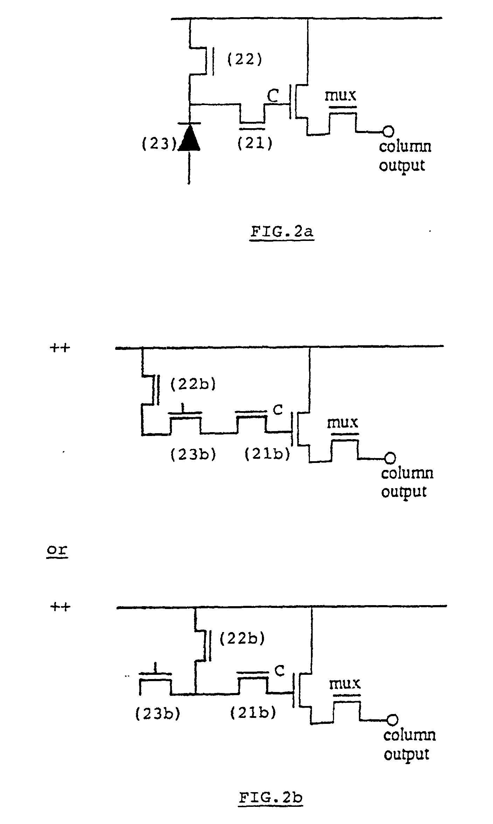

Figure 2 represents a specific embodiment of the schematic structure as represented in Figure 1. The pixel therein is a 4T (transistor) integrating active pixel. It has the feature of being able to sample through switch (21) a signal level intermediate in the integration slope, on the node C. Afterwards, both signals (the intermediate value and the final integrated value) can be combined in one read-out signal with high dynamic. In the simplest approach, this combination consists of adding both values.

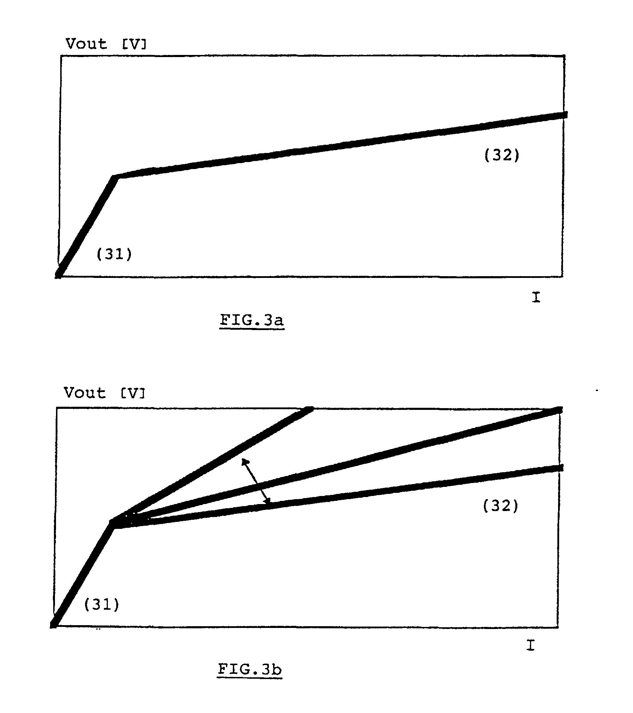

The effective response of such a structure is represented in Figure 3a for an active pixel with a double linear slope having a first (32) and a second (31) part. According to the present invention and as represented in Figure 3b, the slope of the first part (32) can be varied by the electronic shutter ratio according to the number of rows in the image. For instance, between a factor of 1 to 250.

The double slope compresses the high intensity part of an image, but preserves the low intensity part. It has a comparable property as the gamma correction or as the logarithmic compression, yet it can be tuned within a wide range to accommodate various light intensity conditions.

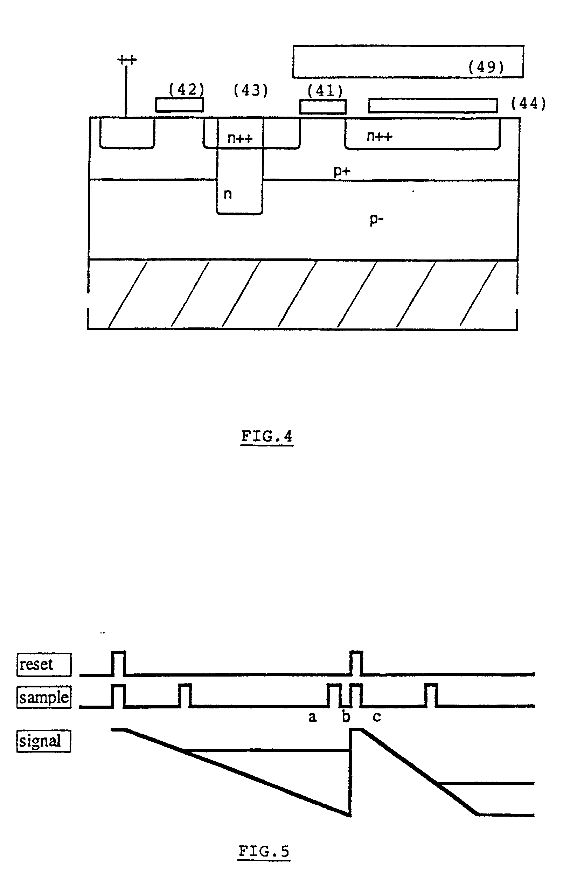

A cross-section of a possible implementation in a CMOS technology of a pixel structure as represented in Figure 1 or 2 is shown in Figure 4 wherein the memory element is also realised as a MOS structure (44) (although it is not necessary to do so); the amplification and multiplexing beyond are not shown. The metal light shield (49) is not necessary, as the operation of the pixel structure tolerates some charge collection. Further shown in figure 4 is a silicon substrate wherein a photosensitive element (43) as a (n⁺⁺)n/p- junction; a first switch (41) and a second switch (42) as metal or polysilicon layers separated from the silicon substrate in fact from (the p⁺ surface layer) by a dielectric layer.

The analog memory element is represented by the capacitor component (44) which has a part or parts which are junctions, or which has connections to other circuit elements (in casu transistors) which have junctions. Junctions are light sensitive, and this light sensitivity will cause a current flow which will affect the charge stored on the capacitor (44). Such memory element or capacitor (44) can be used for various purposes : spatial and temporal filtering, the memorisation of image, etc.

The above circuit should, in order to operate in the best mode, have a stable signal on capacitor (44). Hereto, the capacitor and also the interconnections to it should be shielded from the light, which is straightforward by using a metallisation. However, the capacitor and/or interconnection elements to it may also collect charge that is present in the chip's substrate due to light falling on it. Especially, photo charge that is being created deep in the substrate can diffuse easily onto capacitor (44) or its interconnections, and (dis-)charge them.

If the photo diode (43) or another diode, not part of the capacitor (44) is made according to the embodiment of Figure 4, the wandering charge in the substrate of the chip will likely be collected there, and will thus not affect the charge on the capacitor (44).

The present invention is also related to preferred methods of reading the signal of a CMOS based pixel structure in order to obtain a double or multiple linear slope for a dynamic response. According to the first preferred embodiment, as represented in Figure 5, several pulses can be applied to the reset (22) and to the switch (21) of the pixel structure of figure 2.

On Figure 5, the reset is represented on the first line, the sample on the second and the potential level seen on the photodiode output node and on the node C on the third line.

Two integration periods are shown on Figure 5. A certain time after the reset pulse, the switch (21) is opened for a short while, thus freezing this potential on the node (capacitor) C. At the end of the first integration period, the switch (21) is shortly opened, and the recent potential on the photodiode output node is sampled.

In the present embodiment, a weighted average of the recent potential on the photodiode output node and of the potential that was frozen on the capacitor C is sampled (signal "b"). After reset (closing of switch 22), the reset level of the pixel is sampled again (signal "c") which might be useful for offset correction, correlated double sampling etc. This signal sample ("b") is sufficient to obtain a double linear response, as this sample is in itself the average of the potential on capacitor C and on the photodiode, which are the electrical responses with low and high sensitivity themselves. Difference (b-c) is a correlated double sampled version of this signal thus removing eventual offset non-uniformity.

In a more general teaching and without reference to the pixel structure of figure 2, in figure 5, the method of the invention is schematically shown.

On Figure 5, the reset is represented on the first line, the sample on the second and the potential level seen on the photodiode output node and on the node C on the third line. A certain time after the reset pulse, the sample is opened for a short while, thus freezing this potential on capacitor C.

At the end of the integration period, the memorized value on the capacitor C is sampled ("a"), then the sample switch is shortly opened, and the recent potential on the photodiode output node is sampled ("b"). After reset, the reset value of the pixel is sampled, which might be useful for offset correction, correlated double sampling etc.

Values a and b, or in a correlated double sampling configuration, (c-a) and (c-b) are the responses with low and high responsivity respectively. Both values can be combined externally to the pixel, inside or outside the image sensor. The simple way of combination is a linear combination, yielding effective response curves as shown in figure 3.

Values a and b, or in a correlated double sampling configuration (c-a) and (c-b) are the responses with low and high responsivity respectively. Both values can be combined externally to the pixel, inside or outside to the image sensor. A simple way of combination is a linear or even non linear combination, yielding an effective response curve as shown in figure 3a.

In an embodiment of the present invention, a pixel structure is made in a 0.7 µm CMOS technology and fabricated at MITEC. The pixel of the invention shows a dynamic range of about 1:20000 to 1:60000 whereas a reference pixel without the characteristics of the invention and fabricated in the same technology shows a dynamic range of about 1:2000 to 1:3000.

## Claims

1. A method for obtaining a read-out signal of a MOS-based pixel structure having in a MOS technology at least a photosensitive element (3) with an output node and a memory element (4) with a first switch (1) therebetween, the method comprising the steps of while acquiring, during an integration period, charge carriers on said output node of said photosensitive element (3), said charge carriers being converted from radiation impinging on the photosensitive element (3):
- after a first time period of said integration period, opening said first switch (1) thereby storing a first number of charge carriers on said memory element (4) and creating a first signal (a);
- after a second time period of said integration period, creating a second signal (b) from a second number of charge carriers being stored on said output node of said photosensitive element (3), and
- combining at least said first and said second signals (a, b) to form an average thereof in order to obtain said read-out signal.

2. The method as recited in claim 1, wherein the read-out signal is a weighted average of said first and said second signals.

3. The method according to claim 1 or 2 wherein the read-out signal has a multiple linear response with respect to the radiation impinging on the photosensitive element.

4. The method according to any of claims 1 to 3, wherein said steps are repeated for a number of time periods larger than 2.

5. The method as recited in claim 1, further comprising the steps of:
- after said second time period, creating a first intermediate signal from said first signal,
- thereafter opening and closing said first switch (1) thereby creating a second intermediate signal; and
- combining at least said first and said second intermediate signals in order to obtain said read-out signal.

6. The method as recited in claim 1, wherein all the voltages applied on said pixel structure are the same during the first and second time periods.

7. The method as recited in claim 5, wherein the read-out signal is a weighted average of at least said first and said second intermediate signals.

8. The method according to claim 5, wherein the read-out signal is a linear combination of said second and first intermediate signals.

9. The method as recited in claim 5, wherein a correlated double sampling is performed using an extra step of closing a reset switch (2) which is placed in series with the photosensitive element (3) in order to have a reset of said photosensitive element (3) and thereby creating a third signal (c), said read-out signal being a combination of said first, second and third signals (a, b, c).

10. The method as recited in claim 9, wherein the read-out signal is a combination of the subtraction of third and first signals (c-a) and of the subtraction of third and second signals (c-b).

11. The method as recited in claim 9, wherein the read-out signal is a combination of the subtraction of second and first signals (b-a) and of the subtraction of third and second signals (c-b).

12. The method as recited in claim 9, wherein the read-out signal is a combination of the subtraction of second and first signals (b-a) and of the subtraction of third and first signals (c-a).

13. A MOS-based pixel structure, comprising at least:
- a photosensitive element (3; 23) with an output node for converting radiation into charge carriers, and being connected to a voltage (++) with a reset switch (2; 22) between the output node and the voltage (++);
- a memory element (4; C) being connected to an amplifier (A);
- a first switch (1; 21) in-between said photosensitive element (3; 23) and said memory element (4; C), said first switch (1; 21) being opened after a first time period, causing a first number of said charge carriers to be stored on said memory element (4; C) and a first signal (a) to be created, said first switch (1; 21) being closed again after a second time period of the same integration period, causing a second signal (b) to be created from a second number of charge carriers stored on the connection between the photosensitive element (3; 23) and the reset switch (2; 22).

14. A MOS-based pixel structure according to claim 13, wherein the memory element is an analog memory such as a capacitor (4) or a parasitic capacitor (C).

15. A MOS-based pixel structure according to claim 14, wherein said memory element forms an average of the first signal (a) and second signal (b).

16. A MOS-base pixel structure according to claim 13, wherein both switches (1, 21; 2, 22) are CMOS transistors.

17. A MOS-based pixel structure according to any one of the preceding claims 13 to 16, wherein said amplifier (A) is placed within the pixel structure in order to have an active pixel.

18. A MOS-based pixel structure according to any one of the preceding claims 13 to 17, wherein said amplifier (A) is placed outside of the pixel structure in order to have a passive pixel structure.

19. A MOS image sensor having a geometric configuration of pixels consisting in a structure according to any one of the claims 13 to 18.

20. Use of the MOS image sensor as recited in claim 19 or of the method as recited in any of claims 1 to 12 in a camera system.

## Patentansprüche

1. Ein Verfahren zum Erhalten eines Auslesesignals einer auf MOS basierenden Pixelstruktur, welche in einer MOS Technologie mindestens ein lichtempfindliches Element (3) mit einem Ausgangsknoten und ein Speicherelement (4) mit einem ersten Schalter (1) zwischen diesen beiden aufweist, wobei das Verfahren die Schritte aufweist: Während des Sammelns von Ladungsträgern an dem Ausgangsknoten des lichtempfindlichen Elements (3) über eine Integrationsperiode,
- nach einer ersten Zeitperiode der Integrationsperiode, öffnen des ersten Schalters (1), durch eine erste Anzahl von Ladungsträgern auf dem Speicherelement (4) gespeichert und ein erstes Signal (a) erzeugt wird;
- nach einer zweiten Zeitperiode der Integrationsperiode, erzeugen eines zweiten Signals (b) von einer zweiten Anzahl von Ladungsträgern, die auf dem Ausgangsknoten des lichtempfindlichen Elements gespeichert sind, und
- kombinieren vom mindestens dem ersten und dem zweiten Signal (a, b) zum Bilden eines Durchschnittswerts, um das Auslesesignal zu erhalten, wobei die Ladungsträger aus auf das lichtempfindliche Element (3) eintreffender Strahlung umgewandelt werden.

2. Das Verfahren gemäss Anspruch 1, wobei das Auslesesignal ein gewichteter Durchschnittswert des ersten und zweiten Signals ist.

3. Das Verfahren gemäss Anspruch 1 oder 2, in welchem das Auslesesignal eine mehrfach-lineare Ansprechkarakteristik in Bezug auf die Strahlung aufweist, die auf das lichtempfindliche Element eintrifft.

4. Verfahren gemäss einem der Ansprüche 1 bis 3, in welchem die Schritte für eine Anzahl von Zeitperioden wiederholt werden, die grösser als 2 ist.

5. Das Verfahren gemäss Anspruch 1, das weiterhin die folgenden Schritte aufweist:
- erzeugen eines ersten Zwischensignals vom ersten Signal nach der zweiten Zeitperiode,
- anschliessend öffnen und schliessen des ersten Schalters (1), wodurch ein zweites Zwischensignal erzeugt wird; und
- kombinieren von mindestens dem ersten und dem zweiten Zwischensignal, um das Auslesesignal zu erhalten.

6. Das Verfahren gemäss Anspruch 1, in welchem alle an die Pixelstruktur angelegten Spannungen während der ersten und zweiten Zeitperiode gleich sind.

7. Das Verfahren gemäss Anspruch 5, in welchem das Auslesesignal ein gewichteter Durchschnittswert von mindestens dem ersten und dem zweiten Zwischensignal ist.

8. Das Verfahren gemäss Anspruch 5, in welchem das Auslesesignal eine lineare Kombination des zweiten und des erst en Zwischensignals ist.

9. Das Verfahren gemäss Anspruch 5, in welchem ein korreliertes Doppel-Sampling mit einem zusätzlichen Schritt des Schliessens eines mit dem lichtempfindlichen Element (3) in einer Reihe geschalteten Rückstellschalters (2) ausgeführt wird, um ein Zurückzustellen des lichtempfindlichen Elements (3) zu erhalten und somit ein drittes Signal (c) zu erzeugen, wobei das Auslesesignal eine Kombination des ersten, zweiten und dritten Signals (a, b, c) ist.

10. Das Verfahren gemäss Anspruch 9, in welchem das Auslesesignal eine Kombination des Substrahierens des ersten vom dritten Signal (c-a) und des Substrahierens des zweiten vom dritten Signal (c-b) ist.

11. Das Verfahren gemäss Anspruch 9, in welchem das Auslesesignal eine Kombination des Substrahierens des ersten vom zweiten Signal (b-a) und des Substrahierens des zweiten vom dritten Signal (c-b) ist.

12. Das Verfahren gemäss Anspruch 9, in welchem das Auslesesignal eine Kombination des Substrahierens des ersten vom zweiten Signal (b-a) und des Substrahierens des ersten vom dritten Signal (c-a) ist.

13. Eine MOS basierende Pixelstruktur, welche mindestens folgende Elemente aufweist:
- ein lichtempfindliches Element (3;23) mit einem Ausgangsknoten zum Umwandlen von Strahlung in Ladungsträger, das an eine Spannung (++) angeschlossen ist wobei ein Rückstellschalter (2;22) zwischen dem Ausgangsknoten und der Spannung (++) angeordnet ist;
- ein Speicherelement (4; C), das an einem Verstärker (A) angeschlossen ist;
- einen ersten Schalter (1; 21) zwischen dem lichtempfindlichen Element (3; 23) und dem Speicherelement (4; C), wobei der erste Schalter (1; 21) nach einer ersten Zeitperiode geöffnet wird, wodurch eine erste Anzahl von den Ladungsträgern auf dem Speicherelement (4; C) gespeichert werden und ein erstes Signal (a) erzeugt wird, wobei der erste Schalter (1; 21) nach einer zweiten Zeitperiode der gleichen Integrationperiode wieder geschlossen wird, wodurch ein zweites Signal (b) von einer zweiten Anzahl von Ladungsträgern erzeugt wird, die auf der Verbindung zwischen dem lichtempfindlichen Element (3; 23) und dem Rückstellschalter (2; 22) gespeichert sind.

14. Eine auf MOS basierende Pixelstruktur gemäss Anspruch 13, in welcher das Speicherelement ein Analogspeicher wie ein Kondensator (4) oder ein parasitischer Kondensator (C) ist.

15. Eine auf MOS basierende Pixelstruktur gemäss Anspruch 14, in welcher das Speicherelement einen Durchschnittswert aus dem ersten Signal (a) und dem zweiten (b) Signal bildet.

16. Eine auf MOS basierende Pixelstruktur gemäss Anspruch 13, in welcher beide Schalter (1, 21; 2, 22) CMOS-Transistoren sind.

17. Eine auf MOS basierende Pixelstruktur gemäss einem der vorhergehenden Ansprüche 13 bis 16, in welcher der Verstärker (A) in der Pixelstruktur angeordnet ist, um ein aktives Pixel zu erhalten.

18. Eine auf MOS basierende Pixelstruktur gemäss einem der vorhergehenden Ansprüche 13 bis 17, in welcher der Verstärker (A) ausserhalb der Pixelstruktur angeordnet ist, um eine passive Pixelstruktur zu erhalten.

19. Ein MOS-Bildsensor mit einer geometrischen Pixelkonfiguration bestehende aus einer Struktur gemäss einem der Ansprüche 13 bis 18.

20. Anwendung des MOS-Bildsensors gemäss Anspruch 19 oder eines Verfahrens gemäss einem der Ansprüche 1 bis 12 in einem Kamerasystem.

## Revendications

1. Une méthode pour obtenir un signal de lecture de sortie d'une structure de pixels de type MOS ayant dans une technologie MOS au moins un élément photosensible (3) avec un noeud de sortie et un élément de mémoire (4) avec un premier commutateur (1) entre eux, la méthode comprenant, tout en acquérant, pendant une période d'intégration, des porteurs de charge sur ledit noeud de sortie dudit élément photosensible (3), lesdits porteurs de charge étant convertis de la radiation empiétant sur l'élément photosensible (3), les étapes consistant à:
- après une première période de temps de ladite période d'intégration, ouvrir ledit premier commutateur (1) stockant ainsi un premier nombre de porteurs de charge sur ledit élément de mémoire (4) et créant un premier signal (a) ;
- après une deuxième période de temps de ladite période d'intégration, créer un deuxième signal (b) à partir d'un deuxième nombre de porteurs de charge stockés sur ledit noeud de sortie dudit élément photosensible (3), et
- combiner au moins lesdits premier et deuxième signaux (a, b) pour en former une moyenne afin d'obtenir ledit signal de lecture de sortie.

2. La méthode telle qu'énoncée dans la revendication 1, dans laquelle le signal de lecture de sortie est une moyenne pondérée desdits premier et deuxième signaux.

3. La méthode selon la revendication 1 ou 2, dans laquelle le signal de lecture de sortie a une réponse linéaire multiple par rapport à la radiation empiétant sur l'élément photosensible.

4. La méthode selon l'une quelconque des revendications 1 à 3, dans laquelle lesdites étapes sont répétées un nombre de périodes de temps supérieur à 2.

5. La méthode telle qu'énoncée dans la revendication 1, comprenant en outre les étapes consistant à:
- après ladite deuxième période de temps, créer un premier signal intermédiaire à partir dudit premier signal,
- par la suite, ouvrir et fermer ledit premier commutateur (1) créant ainsi un deuxième signal intermédiaire; et
- combiner au moins lesdits premier et deuxième signaux intermédiaires afin d'obtenir ledit signal de lecture de sortie.

6. La méthode telle qu'énoncée dans la revendication 1, dans laquelle toutes les tensions appliquées sur ladite structure de pixels sont les mêmes pendant les première et deuxième périodes de temps.

7. La méthode telle qu'énoncée dans la revendication 5, dans laquelle le signal de lecture de sortie est une moyenne pondérée d'au moins lesdits premier et deuxième signaux intermédiaires.

8. La méthode selon la revendication 5, dans laquelle le signal de lecture de sortie est une combinaison linéaire desdits deuxième et premier signaux intermédiaires.

9. La méthode telle qu'énoncée dans la revendication 5, dans laquelle un échantillonnage double corrélé est effectué en utilisant une étape supplémentaire de fermeture d'un commutateur de remise à zéro (2) qui est placé en série avec l'élément photosensible (3) afin d'avoir une remise à zéro dudit élément photosensible (3) et de créer ainsi un troisième signal (c), ledit signal de lecture de sortie étant une combinaison desdits premier, deuxième et troisième signaux (a, b, c).

10. La méthode telle qu'énoncée dans la revendication 9, dans laquelle le signal de lecture de sortie est une combinaison de la soustraction des troisième et premier signaux (c-a) et de la soustraction des troisième et deuxième signaux (c-b).

11. La méthode telle qu'énoncée dans la revendication 9, dans laquelle le signal de lecture de sortie est une combinaison de la soustraction des deuxième et premier signaux (b-a) et de la soustraction des troisième et deuxième signaux (c-b).

12. La méthode telle qu'énoncée dans la revendication 9, dans laquelle le signal de lecture de sortie est une combinaison de la soustraction des deuxième et premier signaux (b-a) et de la soustraction des troisième et premier signaux (c-a).

13. Une structure de pixels de type MOS, comprenant au moins:
- un élément photosensible (3; 23) avec un noeud de sortie pour convertir de la radiation en porteurs de charge, et étant connecté à une tension (++) avec un commutateur de remise à zéro (2; 22) entre le noeud de sortie et la tension (++);
- un élément de mémoire (4; C) étant connecté à un amplificateur (A);
- un premier commutateur (1; 21) entre ledit élément photosensible (3; 23) et ledit élément de mémoire (4; C), ledit premier commutateur (1; 21) étant ouvert après une première période de temps, causant le stockage d'un premier nombre desdits porteurs de charge sur ledit élément de mémoire (4; C) et la création d'un premier signal (a), ledit premier commutateur (1; 21) étant à nouveau fermé après une deuxième période de temps de la même période d'intégration, causant la création d'un deuxième signal (b) à partir d'un deuxième nombre de porteurs de charge stockés sur la connexion entre l'élément photosensible (3; 23) et le commutateur de remise à zéro (2; 22).

14. Une structure de pixels de type MOS selon la revendication 13, dans laquelle l'élément de mémoire est une mémoire analogique telle un condensateur (4) ou un condensateur parasite(C).

15. Une structure de pixels de type MOS selon la revendication 14, dans laquelle ledit élément de mémoire forme une moyenne du premier signal (a) et du deuxième signal (b).

16. Une structure de pixels de type MOS selon la revendication 13, dans laquelle les deux commutateurs (1, 21 ; 2, 22) sont des transistors CMOS.

17. Une structure de pixels de type MOS selon l'une quelconque des revendications précédentes 13 à 16, dans laquelle ledit amplificateur (A) est placé à l'intérieur la structure de pixels afin d'avoir un pixel actif.

18. Une structure de pixels de type MOS selon l'une quelconque des revendications précédentes 13 à 17, dans laquelle ledit amplificateur (A) est placé en dehors de la structure de pixels afin d'avoir une structure de pixels passifs.

19. Un capteur d'image MOS ayant une configuration géométrique de pixels consistant en une structure selon l'une quelconque des revendications 13 à 18.

20. Utilisation du capteur d'image MOS telle qu'énoncée dans la revendication 19 ou de la méthode telle qu'énoncée dans l'une quelconque des revendications 1 à 12 dans un système de caméra.
